Europäisches Patentamt

European Patent Office

Office européen des brevets

(11) Veröffentlichungsnummer: **0 267 507**
**A2**

(12) **EUROPÄISCHE PATENTANMELDUNG**

(21) Anmeldenummer: 87116041.2

(51) Int. Cl.⁴: **H01L 21/00**

(22) Anmeldetag: 31.10.87

(30) Priorität: 06.11.86 DE 3637880

(43) Veröffentlichungstag der Anmeldung:
18.05.88 Patentblatt 88/20

(84) Benannte Vertragsstaaten:
AT BE CH DE ES FR GB IT LI LU NL SE

(71) Anmelder: Meissner & Wurst GmbH & Co.
Lufttechnische Anlagen
Rossbachstrasse 38
D-7000 Stuttgart 31(DE)

(72) Erfinder: Wurst, Manfred P., Dipl.-Ing.
Thüringerwaldstrasse 32
D-7000 Stuttgart 30(DE)
Erfinder: Simon, Rudolf, Dr.-Ing.
Lessingstrasse 1
D-7015 Korntal-Münchingen(DE)
Erfinder: Von Kahlden, Thomas, Dipl.-Ing.
Robert-Leicht-Strasse 131
D-7000 Stuttgart 80(DE)

(74) Vertreter: Jackisch, Walter, Dipl.-Ing.
Menzelstrasse 40
D-7000 Stuttgart 1(DE)

(54) **Behältnis zur Handhabung von Halbleiterelementen und Verfahren zur partikelfreien Übergabe.**

(57) Halbleiterelemente werden während des Transportes in allseitig geschlossenen Behältnissen transportiert, damit sie nicht verschmutzen. Das Behältnis kann nur unter reinen Raumbedingungen geöffnet werden. Durch das neue Behältnis und das neue Verfahren soll keine Verschmutzung auftreten, selbst wenn das Behältnis nicht unter Reinraumbedingungen gelagert oder gehandhabt wird.

Im Behältnis werden Halbleiterelemente (2) von einem gerichteten, zumindest annähernd laminaren Reinluftstrom im Reinluftbereich umspült. In dem einen Reinluftbereich herrscht hierbei ein höherer statischer Druck als in dem mit unzulässig vielen Partikeln belasteten Umgebungsraum. Der Reinluftstrom reißt eventuell noch vorhandene Schmutzteilchen mit, so daß sie sich nicht auf den Halbleiterelementen (2) ablagern können. Infolge des höheren statischen Druckes wird eine Zwangsströmung aus dem Reinluftbereich des höheren statischen Druckes nach außen in den Umgebungsraum erzielt, wodurch ein Eintritt von Schmutzteilchen aus dem Umgebungsraum verhindert wird.

Fig. 1

## Behältnis zur Handhabung von Halbleiterelementen und Verfahren zur partikelfreien Übergabe

Die Erfindung betrifft ein Behältnis zur Handhabung von Halbleiterelementen nach dem Oberbegriff des Anspruches 1 und ein Verfahren zur partikelfreien Übergabe nach dem Oberbegriff des Anspruches 12.

Mit einem solchen bekannten Behältnis werden Halbleiterscheiben, sogenannte Wafer, von einem Reinraum in einen anderen Reinraum transportiert. Die Halbleiterscheiben werden für die Herstellung von Mikrochips verwendet und dürfen nur in extrem reinen Räumen bearbeitet werden. Es ist daher dafür zu sorgen, daß während des Transportes diese Halbleiterscheiben nicht verschmutzen. Aus diesem Grunde ist bei dem bekannten Behältnis der Reinraum allseitig geschlossen. Der Boden dieses Behältnisses ist abnehmbar, so daß der Träger mit den Halbleiterscheiben in den Reinraum des Behältnisses eingebracht bzw. aus ihm herausgenommen werden kann. Dieses Behältnis kann nur unter reinen Raumbedingungen geöffnet werden, da andernfalls Schmutzpartikel sofort zu den Halbleiterscheiben gelangen und sich an ihnen ablagern könnten. Für den luftdichten Verschluß dieses Behältnisses ist ein erheblicher Aufwand notwendig. Zudem besteht die Gefahr, daß dieser Verschluß beschädigt wird, so daß dann Schmutzpartikel bzw. Staubteilchen in den Reinraum gelangen und die Halbleiterscheiben verschmutzen. Die im Reinraum noch befindliche Luft ist auch bei größter Reinheit noch mit Staubteilchen und Schmutzpartikeln versehen, so daß die Gefahr besteht, daß selbst bei einwandfreiem Verschluß diese Schmutzpartikel auf die Halbleiterscheiben gelangen. Die bei der Halbleiterbearbeitung verwendeten Chemikalien entwickeln Gase, die sich bei längerer Lagerung in dem geschlossenen Reinraum so stark anreichern können, daß sie die Oberfläche der Halbleiterscheiben nachteilig verändern.

Bei der partikelfreien Übergabe von Halbleiterscheiben ist es bekannt, das luftdicht verschlossene Behältnis an die Wandung einer gesonderten Beladestation anzuschließen und dann den Boden des Behältnisses zu öffnen. Hierbei muß aber dafür gesorgt werden, daß aus der mit Schmutzpartikeln belasteten Umgebungsluft keine Schmutzteilchen nach innen in das Behältnis und/oder die Beladestation gelangen. Darum muß in aufwendiger Weise der Anschlußbereich des Behältnisses an die Beladestation mit Dichtungen und dgl. abgedichtet werden. Dadurch besteht aber die Gefahr, daß bei schadhafter Dichtung oder wenn die Dichtung nicht sauber eingelegt ist, die Schmutzpartikel aus der Umgebungsluft durch die undichte Dichtstelle hindurch in das Behältnis und/oder die Beladestation gelangen.

Der Erfindung liegt die Aufgabe zugrunde, das gattungsgemäße Behältnis und das gattungsgemäße Verfahren so auszubilden, daß bei einfachster konstruktiver Ausgestaltung im Reinluftbereich keine Verschmutzung auftritt, selbst wenn das Behältnis nicht unter Reinraumbedingungen gelagert oder gehandhabt wird. Insbesondere soll bei der kritischen Übergabe zwischen zwei Reinluftbereichen ohne großen konstruktiven Aufwand sichergestellt sein, daß keine Schmutzpartikel aus dem Umgebungsraum in die Reinluftbereiche gelangen.

Diese Aufgabe wird beim gattungsgemäßen Behältnis erfindungsgemäß mit den kennzeichnenden Merkmalen des Anspruches 1 und beim gattungsgemäßen Verfahren erfindungsgemäß mit den kennzeichnenden Merkmalen des Anspruches 12 gelöst.

Die Halbleiterelemente werden im Reinluftbereich des erfindungsgemäßen Behältnisses ständig von dem gerichteten Reinluftstrom umspült, so daß eventuell noch vorhandene Schmutzteilchen oder Staubpartikel von diesem Luftstrom mitgerissen werden und sich nicht auf den Halbleiterelementen ablagern können. Da die Halbleiterelemente ständig vom Reinluftstrom umströmt werden, werden die sich bildenden Gase durch die Strömung mitgenommen, so daß sie die Oberfläche der Halbleiterelemente nicht angreifen können. Im erfindungsgemäßen Behältnis können darum auch die Halbleiterelemente längere Zeit gelagert werden, ohne daß eine Beschädigung der Halbleiterelemente zu befürchten ist. Während dieser Lagerung werden die Halbleiterelemente ebenfalls ständig vom Reinluftstrom umspült. Infolge dieses Reinluftstromes wird ein Zutritt der Umgebungsluft in den Reinluftbereich des erfindungsgemäßen Behältnisses sicher verhindert. Darum kann das erfindungsgemäße Behältnis auch durch verschmutzte Räume transportiert werden, ohne daß die Gefahr besteht, daß Schmutzteilchen in den Reinluftbereich gelangen. Da das Behältnis keine Dichtungen aufweist, treten die mit ihnen verbundenen Nachteile nicht auf. Außerdem ist der Träger mit den Halbleiterelementen leicht zugänglich, so daß die weitere Handhabung des erfindungsgemäßen Behältnisses ohne Mühe vollautomatisch durchgeführt werden kann.

Beim erfindungsgemäßen Verfahren kann die partikelfreie Übergabe der Produkte durchgeführt werden, ohne daß der kritische Übergabebereich durch gesonderte Dichtelemente und dgl. gegen den Umgebungsraum abgedichtet werden muß. Da beide Reinluftbereiche von der Reinluft durchströmt sind, und zumindest in dem einen Reinluftbereich ein höherer statischer Druck herrscht als im Umgebungsraum, wird eine Zwangsströmung aus dem Reinluftbereich längs des Randes der jeweiligen Übergabeöffnung nach außen erzielt, wodurch ein Eintritt von Schmutzteilchen aus dem Umgebungsraum zuverlässig verhindert wird. Beim erfindungsgemäßen Verfahren sind also keine mechanischen Dichtelemente und dgl. notwendig.

Weitere Merkmale der Erfindung ergeben sich aus den weiteren Ansprüchen, der Beschreibung und den Zeichnungen.

Die Erfindung wird anhand zweier in den Zeichnungen dargestellter Ausführungsbeispiele näher erläutert. Es zeigen

Fig. 1 in schematischer Darstellung eine erste Ausführungsform eines erfindungsgemäßen Behältnisses in Ansicht,

Fig. 2 den Beladevorgang eines Prozeßgerätes mit in einem erfindungsgemäßen Behältnis gem. Fig. 1 untergebrachten Träger,

Fig. 3 mehrere auf einem Transportwagen angeordnete erfindungsgemäße Behältnisse,

Fig. 4 in schematischer Darstellung eine zweite Ausführungsform eines erfindungsgemäßen Behältnisses,

Fig. 5 und 6 zwei Möglichkeiten der partikelfreien Übergabe von Produkten zwischen zwei Reinluftbereichen.

Mit dem Behältnis werden Träger 1 transportiert, in denen Halbleiterscheiben 2, sogenannte Wafer, angeordnet sind. Diese Halbleiterscheiben 2 werden zur Herstellung von Mikrochips verwendet. Die Halbleiterscheiben 2 dürfen nur in extrem reinen Räumen behandelt und transportiert werden, weil schon kleinste Schmutz-oder Staubteilchen die Halbleiterscheiben für die weitere Bearbeitung unbrauchbar machen.

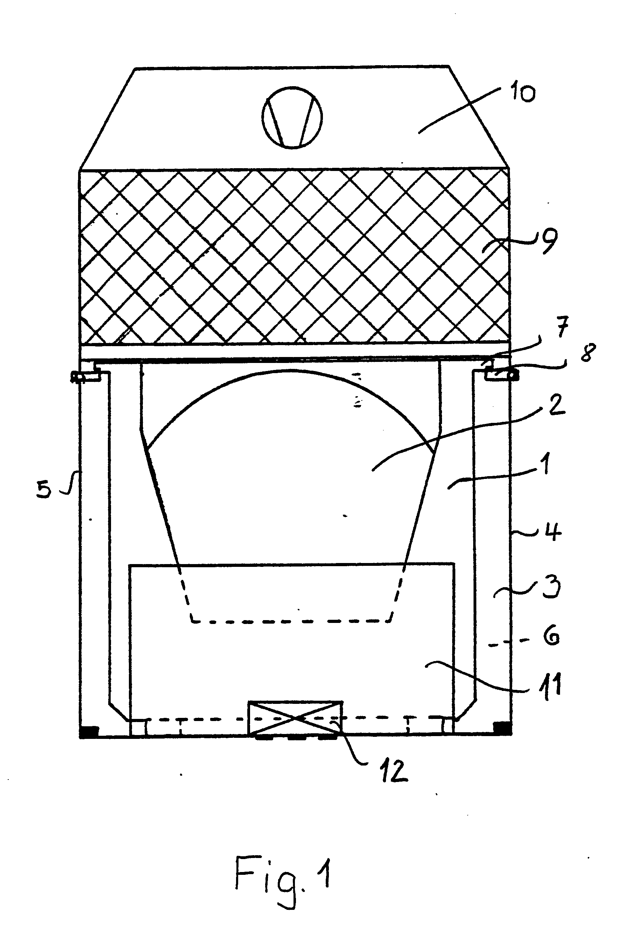

Das Behältnis gem. Fig. 1 hat rechteckigen Grundriß mit vier Seitenwänden, von denen in Fig. 1 die Vorderwand 3 und zwei einander gegenüberliegende Seitenwände 4 und 5 dargestellt sind:. In dem von den Wänden umschlossenen Reinraum 6 ist der Träger 1 hängend gelagert. Hierzu ist er an seinem oberen Ende mit einem flanschartigen Ansatz 7 versehen, der mit Arretierungen 8, Rastverbindungen und dgl. zusammenwirkt, die an der Innenseite der Seitenwände des Behältnisses vorgesehen sind. Der Reinraum 6 ist nach oben durch mindestens einen Hochleistungs-Schwebstofffilter 9 geschlossen, über dem eine Ventilatoreinheit 10 angeordnet ist. Sie saugt Luft aus dem Umgebungsraum an, die dann durch den Filter 9 strömt. Er hält die in der Luft enthaltenen Staub-und Schmutzteilchen zurück, so daß in den darunterliegenden Reinraum 6 reine Luft strömt. Im Ausführungsbeispiel nach Fig. 1 strömt die reine Luft gerichtet von oben nach unten, wobei der Reinraum 6 über seinen gesamten Querschnitt gleichmäßig in einer Richtung annähernd laminar durchströmt wird. Die Halbleiterscheiben 6 sind im Träger 1 stehend angeordnet, so daß die Reinluft an den Seiten sämtlicher Halbleiterscheiben 2 vorbeiströmt.

Das Behältnis ist auf der der Ventilatoreinheit 10 gegenüberliegenden Seite offen, so daß die annähernd laminar nach unten strömende Reinluft an dieser Seite aus dem Reinraum 6 strömt.

Die Ventilatoreinheit 10 kann auch an einer Seitenwand des Behältnisses angeordnet sein, so daß die Reinluft den Reinraum 6 horizontal durchströmt. In diesem Falle ist das Behältnis auf der gegenüberliegenden Seite offen, während nunmehr der Boden geschlossen ist. Die Halbleiterscheiben 2 liegen dann in Strömungsrichtung, so daß die Reinluft an ihnen vorbeiströmen kann.

Je nach dem gewünschen Reinheitsgrad wird ein entsprechender Hochleistungs-Schwebstofffilter 9 verwendet, so daß die in den Reinraum 6 eintretende Luft auch den gewünschten Reinheitsgrad hat. Durch diese gerichtete laminare Strömung werden eventuell noch vorhandene Partikel im Reinraum 6 mitgerissen und nach außen geführt, so daß sie sich nicht an den Halbleiterscheiben 6 ablagern können. Das Behältnis kann infolge dieser Strömung ohne Gefahr auch durch Räume geringerer Reinheitsklasse transportiert werden, in denen also auch eine größere Zahl von Schmutz-oder Staubteilchen vorhanden sein kann. Die gerichtete Strömung in Reinraum 6 verhindert auch dann, daß solche Schmutz-oder Staubpartikel in das Behältnis gelangen und sich auf den Halbleiterscheiben 2 ablagern können.

Bei der Halbleiterbearbeitung werden Chemikalien verwendet, die zu einer Gasbildung führen. Da die Halbleiterscheiben 2 ständig von Reinluft umströmt werden, werden diese sich bildenden Gase mitgenommen, so daß sie die Oberfläche der Halbleiterscheiben nicht angreifen können.

Zum Betrieb der Ventilatoreinheit 10 ist das Behältnis mit mindestens einem Akku 11 oder einer Batterie ausgestattet, mit dem die Ventilatoreinheit angetrieben werden kann. Wenn sich das Behältnis an einer Entlade-oder Beladestelle oder an einer Lagerstelle befindet, wird es an das Stromnetz oder an einen größeren Akku angeschlossen. Hierzu ist das Behältnis mit einem Anschluß 12 bzw. mit einer Schnittstelle versehen, so daß die Ventilatoreinheit 10 nunmehr extern mit dem notwendigen Strom versorgt wird. Gleichzeitig wird hierbei der Akku 11 aufgeladen.

Die Strömungsgeschwindigkeit im Reinraum 6 des Behältnisses wird so gewählt, daß bei normaler Handhabung keine Luft von außen in den Reinraum gelangen kann. Die Strömungsgeschwindigkeit liegt zweckmäßig bei etwa 0,45 m/sec. Diese Strömungsgeschwindigkeit hat sich bei Großreinräumen bewährt. Aufgrund dieser Strömungsgeschwindigkeit bildet sich, bezogen auf den Druck im verschmutzten Umgebungsraum, im Reinraum 6 ein geringer dynamischer Druck.

Zur Erhöhung des statischen Überdruckes ist es zweckmäßig, an der Unterseite des Behältnisses am Austrittsende der Reinluft ein Lochblech vorzusehen. Der Überdruck liegt dann in der Größenordnung von etwa 1 Pa. Das Lochblech beeinträchtigt die Gleichmäßigkeit der gerichteten Strömung im Reinraum 6 nur wenig.

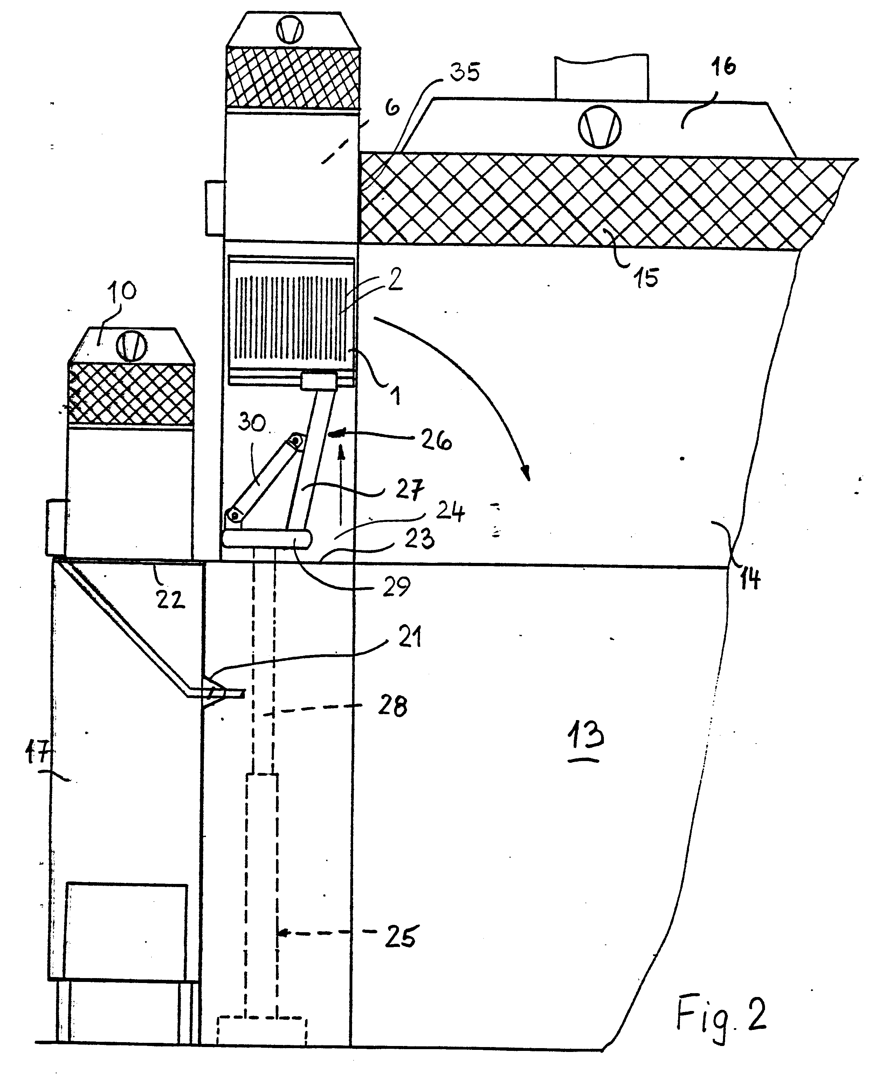

Das Behältnis gem. Fig. 1 hat nur geringes Gewicht und kann darum bequem von Hand transportiert werden. Das Beladen des Behältnisses mit dem Träger 1 und den Halbleiterscheiben 2 erfolgt unter reinraumgerechten Bedingungen. Wird das Behältnis von Hand transportiert, wird die Ventilatoreinheit 10 über den internen Akku 11 betrieben, so daß ständig Reinluft an den Halbleiterscheiben 2 vorbei nach außen strömt. Das Behältnis dient dazu, die Halbleiterscheiben 2 von der Beladestelle aus z.B. zu einem Prozeßgerät 13 zu transportieren (Fig. 2), in dem die Halbleiterscheiben weiter bearbeitet werden. Der im Behältnis befindliche Träger 1 mit den Halbleiterscheiben 2 wird am Prozeßgerät 13 unter reinraumgerechten Bedingungen entnommen, so daß die Reinheitsbedingungen, die im Behältnis herrschen, beim Entnahmevorgang nicht verschlechtert werden. Dieser Entladevorgang erfolgt demnach entweder im Reinraum bzw. am oder im Prozeßgerät 13. Im Ausführungsbeispiel hat das Prozeßgerät 13 einen Entladeraum 14, der von oben nach unten von Reinluft annähernd laminar durchströmt wird. Dieser Entladeraum 14 ist nach oben durch mindestens einen Hochleistungs-Schwebstoffilter 15 abgedeckt, über dem sich eine Ventilatoreinheit 16 befindet. Sie saugt aus dem Umgebungsraum Luft an und drückt sie durch den Filter 15, der die Schmutz-und Staubteilchen zurückhält. Je nach den geforderten Reinheitsbedingungen wird der Filter 15 ausgewählt.

Beim Entladen des Behältnisses wird der Träger 1 mit den Halbleiterscheiben 2 ständig weiterhin von Reinluft laminar umspült, so daß sich an ihnen keine Schmutz-und Staubteilchen absetzen können. Da auch im Entladeraum 14 eine solche laminare Strömung vorhanden ist, wird auch hier zuverlässig die Ablagerung solcher Verunreinigungen auf den Halbleiterscheiben 2 in sehr einfacher Weise zuverlässig verhindert.

Wenn sich das Behältnis am oder im Prozeßgerät 13 befindet, wird die Ventilatoreinheit 10 über den Anschluß 12 von der Stromversorgung des Prozeßgerätes 13 aus angetrieben und gleichzeitig der interne Akku 11 des Behältnisses aufgeladen.

Da das Behältnis an einer Seite offen ist, kann der Träger 1 mit den Halbleiterscheiben 2 in einfacher Weise dem Reinraum 6 entnommen werden.

Es ist auch eine Ausführungsform möglich, bei der das Behältnis keine den Reinraum 6 begrenzende Seitenwände hat. Der Träger 1 wird dann an einer unterhalb oder neben dem Filter 9 befindlichen Halterung aufgehängt. Der vom Ventilator 10 erzeugte Luftstrom umspült hierbei ebenfalls die Halbleiterscheiben 2 und verhindert den Zutritt von Schmutzpartikeln aus der Umgebungsluft.

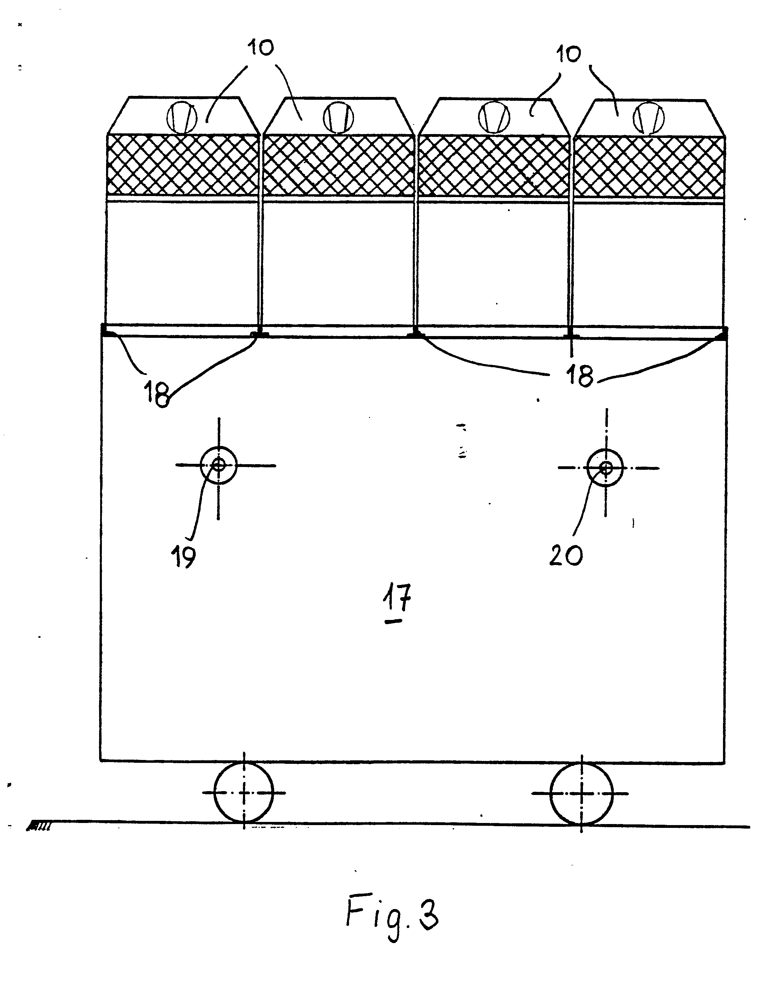

Der Träger 1 kann unterschiedliche Größen haben, je nach Größe der zu transportierenden Halbleiterscheiben 2. Bei größeren Trägern 1 kann das Behältnis ein höheres Gewicht aufweisen, so daß es schwierig ist, das Behältnis von Hand zu transportieren. Für diesen Fall ist ein Transportwagen 17 vorgesehen (Fig. 3), auf dem das Behältnis abgesetzt werden kann. Auf ihm können, wie Fig. 3 zeigt, mehrere Behältnisse abgesetzt werden. Damit die aus den Behältnissen nach unten aus dem Reinraum 6 austretende Luft nicht in den Reinraum zurück umgelenkt wird, stehen die Behältnisse auf nicht näher dargestellten Auflagern, so daß die gerichtete Strömung nach unten aus dem Reinraum der Behältnisse austreten kann. Auf dem Transportwagen 17 sind Lager 18 vorgesehen, auf denen die Behältnisse aufsitzen. Diese Lager können als Rollen-oder als Luftlager ausgebildet sein, auf denen die Behältnisse vom Transportwagen beispielsweise auf das Prozeßgerät 13 verschoben werden können. Der Transportwagen 17 ist mit einem Anschluß 19 für die Stromversorgung und mit einem Anschluß 20 für eine Höheneinstellung zumindest der Auflagerfläche für die Behältnisse versehen.

Auf dem Transportwagen 17 können die Behältnisse zum Prozeßgerät 13 gefahren werden. Während der Fahrt auf dem Transportwagen 17 sind die Ventilatoreinheiten 10 der Behältnisse an die Stromversorgung des Transportwagens angeschlossen, wobei die Akkus 11 der Behältnisse gleichzeitig über diese Stromversorgung aufgeladen werden können. Damit ist sichergestellt, daß die Behältnisse während des Transports auf dem Wagen 17 betriebssicher arbeiten und in den jeweiligen Reinräumen 6 die nach unten gerichtete laminare Strömung vorhanden ist.

Der Transportwagen 17 wird an das Prozeßgerät 13 angeschlossen, wie Fig. 2 zeigt. Hierzu ist das Prozeßgerät 13 mit einem Anschluß 21 versehen, an den zur Stromversorgung der Transportwagen 17 angeschlossen wird. Hierbei werden auch die auf dem Transportwagen befindlichen Behältnisse mit dem notwendigen Strom versorgt, um die Ventilatoreinheiten 10 anzutreiben. Außerdem wird der Anschluß 20 des Transportwagens 17 an einen entsprechenden (nicht dargestellten) Anschluß des Prozeßgerätes 13 angeschlossen, so daß in der in Fig. 2 dargestellten Lage die Auflagefläche des Transportwagens für die Behältnisse in der Höhe verstellt werden kann. Dadurch kann die Auflagerfläche 22 so an die Auflagerfläche 23 des Prozeßgerätes 13 angepaßt werden, daß die Behältnisse ohne Schwierigkeiten vom Transportwagen auf das Prozeßgerät verschoben werden können.

An der Übergabestelle 24 des Prozeßgerätes 13 befindet sich mindestens eine Hubeinheit 25, mit der die Träger 1 der Behältnisse mit den eingesetzten Halbleiterscheiben 2 aus dem Behältnis herausgenommen und in das Prozeßgerät 13 transportiert werden können.

Die in die Übergangsstelle 24 verschobenen Behältnisse werden in die in Fig. 2 dargestellte Lage angehoben. Anschließend wird mit der Hubeinheit 25 eine Greifeinheit 26 nach oben gefahren, deren Greifer 27 in den Reinraum 6 des jeweiligen Behältnisses einfahren und den dort gelagerten Träger 1 erfassen. Mit den Greifern 27 wird dann der Träger 1 von den Arretierungen 8 gelöst und nach unten in die in Fig. 2 dargestellte Lage abgesenkt. Hierbei wird mittels der Hubeinheit 25 die gesamte Greifeinheit 26 abgesenkt. Auf der Kolbenstange 28 der Hubeinheit 25 befindet sich eine Tragplatte 29, auf der die Greifer 27 - schwenkbar gelagert sind. Zum Verschwenken der Greifer 27 dient eine Kolbenzylindereinheit 30, die ebenfalls auf der Tragplatte 29 angelenkt und mit den Greifern 26 gelenkig verbunden ist. Wenn die Greifeinheit 26 in die in Fig. 2 dargestellte Lage abgesenkt worden ist, wird die Kolbenzylindereinheit 30 betätigt und die Greifer 26 mit den Trägern 1 im Uhrzeigersinn verschwenkt und in den Entladeraum 14 des Prozeßgerätes 13 gebracht. Im Entladeraum 14 wird dann der Träger 1 abgesetzt. Die Greifer 27 werden wieder zurückgeschwenkt und die Greifeinheit 26 mit der Hubeinheit 25 unter die Auflagerfläche 23 abgesenkt. Während des beschriebenen Übergangsvorganges strömt reine Luft aus dem jeweiligen Behältnis sowie im Entladeraum 14 des Prozeßgerätes 13 nach unten, so daß die im Träger 1 befindlichen Halbleiterscheiben 2 ständig von Reinluft umspült werden. Dadurch ist sichergestellt, daß sich bei diesem Übergabevorgang keine Schmutzteilchen oder Staubpartikel auf den Halbleiterscheiben absetzen können.

Im Entladeraum 14, der einen Reinraum darstellt, kann die Auflagerfläche für die Träger 1 durch ein Lochblech, ein Gitter oder einen sonstigen luftdurchlässigen Auflagerteil gebildet sein. Mit diesem kann der notwendige Überdruck im Entladeraum 14, bezogen auf den Druck im verschmutzten Umgebungsraum, in einfacher Weise erzeugt werden, ohne die laminare gerichtete Strömung im Entladeraum 14 wesentlich zu behindern.

Im Bereich der Übergabestelle ist die entsprechende Wandung des Entladeraumes 14 mit einer (nicht dargestellten) Übergabeöffnung versehen, durch welche die Träger 1 mit der Greifeinheit 26 in den Entladeraum transportiert werden. Im dargestellten Ausführungsbeispiel ist die Übergabestelle 24 in Richtung auf den Transportwagen 17 offen. Infolge des Überdruckes im Entladeraum 14 strömt die Luft durch die Übergabeöffnung in der der Übergabestelle 24 zugewandten Wandung, wodurch die von oben nach unten aus dem Behältnis strömende Luft entsprechend abgelenkt wird. Hierdurch wird zuverlässig verhindert, daß kontaminierte Luft aus dem Umgebungsraum während des beschriebenen Übergabevorganges an die Halbleiterscheiben 2 gelangt.

Bei einer anderen (nicht dargestellten) Ausführungsform ist die Übergabestelle 24 von Seitenwänden umgeben, von denen die dem Transportwagen 17 zugewandte Seitenwand eine Übergabeöffnung aufweist, damit das Behältnis vom Transportwagen in die Übergabestelle gebracht werden kann. Vorzugsweise ist diese Übergabeöffnung verschließbar, die nach dem Einbringen des Behältnisses in die Übergabestelle 24 geschlossen wird. Durch die aus dem Behältnis strömende Luft wird in der Übergabestelle 24 nunmehr ein Überdruck aufgebaut, bezogen auf den Druck im Umgebungsraum. Die Übergabestelle 24 ist nach oben durch das angehobene Behältnis geschlossen (Fig. 2). Dieser Überdruck in der Übergabestelle 24 ist gleich oder annähernd gleich wie der Überdruck im Entladeraum 14. Das Behältnis muß darum nicht mehr gegenüber den Seitenwänden der Übergabestelle 24 und der benachbarten Wand 35 des Entladeraumes 14 abgedichtet werden. Infolge des Überdruckes strömt die reine Luft im Spalt zwischen dem Behältnis und der entsprechenden Wand des Entladeraumes 14 allseits nach außen und verhindert dadurch den Zutritt von verschmutzter Luft aus dem Umgebungsraum. Es müssen darum keine besonderen Abdichtmaßnahmen vorgesehen werden. Infolge dieser allseits nach außen gerichteten Strömung bildet sich eine partikelfreie Übergabezone, so daß die Halbleiterscheiben 2 ohne Gefahr der Verschmutzung aus dem Behältnis in den Entladeraum 14 und umgekehrt gebracht werden können.

Anstelle der Greifeinheit 26 kann jede andere geeignete Transporteinrichtung verwendet werden, um die Träger 1 in den Entladeraum 14 und aus ihm heraus zu transportieren. Da das Behältnis keinen Boden hat, sind im Prozeßgerät 13 auch keine entsprechenden Öffnungs-und Schließmechanismen notwendig, so daß die Träger 1 sofort von der geöffneten Seite aus dem Behältnis entnommen werden können.

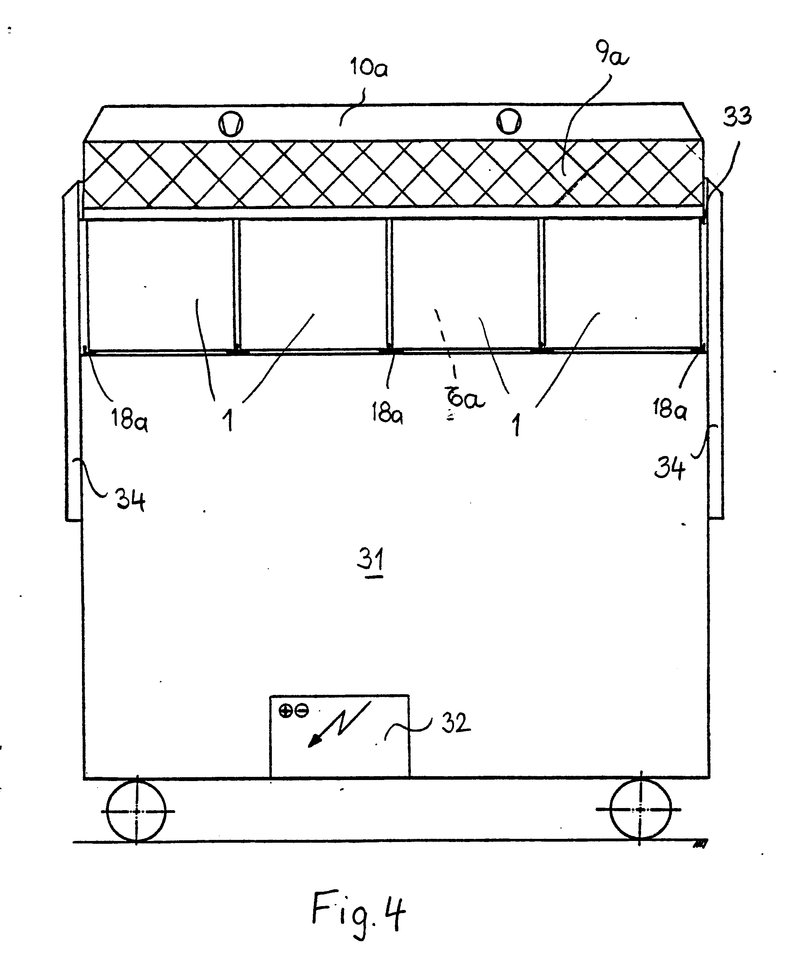

Fig. 4 zeigt eine zweite Ausführungsform eines Behältnisses, das größer ausgebildet und verfahrbar ist. Das Behältnis ist als Transportwagen ausgebildet, mit dem nicht nur ein, sondern mehrere Träger 1 mit Halbleiterscheiben transportiert werden können. Die Träger 1 stehen wiederum auf Lagern 18a, die gleich ausgebildet sind wie die Lager 18 gem. Fig. 3. Sie befinden sich auf einer Transportwageneinheit 31, in der ein Akku 32 zur Stromversorgung der Ventilatoreinheit 10a untergebracht ist. Die Ventilatoreinheit 10a weist zweckmäßig mehrere Ventilatoren auf, so daß sämtliche Träger 1 mit den Halbleiterscheiben gleichmäßig von der nach unten gerichteten Strömung umspült werden. Die Ventilatoreinheit 10a hat ebenso wie die Ventilatoreinheit der vorigen Ausführungsform gleichen Grundriß wie das Behältnis. Unterhalb der Ventilatoreinheit 10a befindet sich wiederum mindestens ein Hochleistungs-Schwebstoffilter 9a, in der die in der angesaugten Luft befindlichen Schmutz-und Staubteilchen gefiltert werden. Die Art des Hochleistungs-Schwebstoffilters 9a richtet sich wiederum nach dem gewünschten Reinheitsgrad im Reinraum 6a. In ihm sind die Träger 1 nebeneinander angeordnet. Sämtliche in den Trägern 1 befindlichen (nicht dargestellten) Halbleiterscheiben werden von der reinen Luft umströmt, so daß eine Ablagerung von Schmutz oder Staubpartikeln auf den Halbleiterscheiben zuverlässig verhindert wird. Die Träger 1 können auf einem Lochblech stehen oder auch hängend im Reinraum 6a gelagert sein. Auf jeden Fall ist der Reinraum 6a so ausgebildet, daß die annähernd laminar strömende Reinluft an sämtlichen Halbleiterscheiben vorbei ungehindert weiter nach unten strömen kann.

Der Reinraum 6a ist so ausgebildet, daß bei der manuellen Entnahme oder beim manuellen Beladen die Halbleiterscheiben in den Trägern nicht verschmutzt werden können. Dies wird dadurch erreicht;.daß der Reinraum 6a so gestaltet ist, daß die Hand der Bedienungsperson mit dem jeweils ergriffenen Träger 1 nicht über die anderen Träger hinwegbewegt werden kann. Auch die Hand der Bedienungsperson selbst kann nicht in den Bereich oberhalb der Träger 1 gelangen. Andernfalls könnten nämlich die an der Hand befindlichen Schmutzpartikel von der strömenden Luft im Reinraum 6a mitgerissen und auf die darunter befindlichen Halbleiterscheiben gelangen. Der Raum zwischen den Trägern 1 und dem Filter 9a ist so schmal ausgebildet, daß die Hand der Bedienungsperson nicht in diesen Spaltbereich gelangen kann. Auch der Filter 9a ist vor Berührung und Beschädigung geschützt. Hierzu ist an der Unterseite des Filters 9a ein (nicht dargestelltes) Lochblech oder ein Streckmetall vorgesehen.

Im Reinraum 6a ist die Strömungsgeschwindigkeit wiederum so hoch, daß ein bestimmter Überdruck gegenüber dem verschmutzten Umgebungsraum gebildet wird. Ein üblicher Wert für die Strömungsgeschwindigkeit im Reinraum 6a beträgt etwa 0,45 m/sec.

Mit der Transportwageneinheit 31 können die Träger 1 an das Prozeßgerät 13 gefahren und dort in den Entladeraum 14 gebracht werden. Da mehrere Träger 1 im Behältnis vorgesehen sind, wird der den Reinraum 6a umschließende Gehäuseteil 33 mit dem Filter 9a und der Ventilatoreinheit 10a angehoben, wozu an der Transportwageneinheit 31 entsprechende Hubeinrichtungen 34 vorgesehen sind. Die Träger 1 können nach dem Anheben des Gehäuseteiles 33 unmittelbar von der Transportwageneinheit 31 in den Entladeraum 14 des Prozeßgerätes 13 geschoben werden. In diesem Falle benötigt das Prozeßgerät nicht mehr die Hubeinheit 25 und die Greifeinheit 26.

Mit den beschriebenen Behältnissen ist es in konstruktiv einfacher Weise möglich, die empfindlichen Halbleiterscheiben 2 im Bearbeitungszustand auch durch verschmutzte Räume zu transportieren. Die in den Behältnissen erzeugte annähernd laminare Strömung von Reinluft sorgt dafür, daß sämtliche im Behältnis befindlichen Halbleiterscheiben allseits von Reinluft umströmt werden, so daß im Reinraum eventuell befindliche Schmutz- oder Staubpartikel mitgerissen werden und sich nicht an den Halbleiterscheiben ablagern können. Die Behältnisse sind darüber hinaus konstruktiv einfach ausgebildet und benötigen keine besonderen Dichtungen, die störanfällig wären und die Handhabung erheblich erschweren wurden. Die Behältnisse sind vielmehr an einer Seite ständig offen, wodurch nicht nur die Dichtprobleme beseitigt sind, sondern auch die Handhabung der Behältnisse äußerst einfach ist.

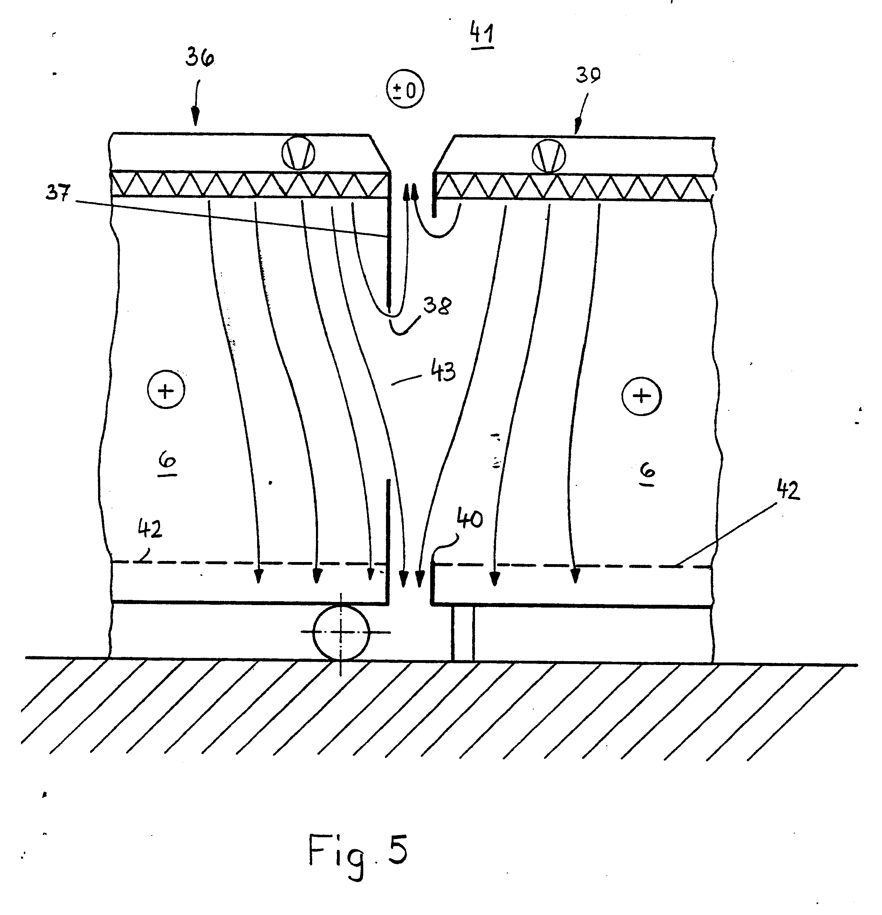

Fig. 5 zeigt eine Möglichkeit, die Halbleiterscheiben aus dem einen Behältnis in das andere Behältnis zu übergeben, ohne daß der Übergabebereich gegen den Umgebungsraum abgedichtet werden muß. Das in Fig. 5 linke Behältnis 36 weist an seiner einen Seitenwand 37 eine Übergabeöffnung 38 auf. Das benachbarte Behältnis 39 ist ebenfalls mit einer Übergabeöffnung 40 versehen. Die beiden Übergabeöffnungen 38 und 40 können unterschiedlich groß sein, wie in Fig. 5 dargestellt ist. Selbstverständlich können die beiden Übergabeöffnungen auch gleich groß sein. Beide Behältnisse 36 und 39 werden in der beschriebenen Weise von zumindest annähernd laminarer Reinluft durchströmt, die durch Pfeile in Fig. 5 gekennzeichnet ist. Im Reinraum 6 dieser beiden Behältnisse wird wiederum in der beschriebenen Weise ein Überdruck aufgebaut, bezogen auf den Überdruck im Umgebungsraum 41. Dieser Überdruck ist in den beiden Behältnissen 36 und 39 durch " + " kenntlich gemacht. Der Druck im Umgebungsraum 41 ist in Fig. 5 durch "± 0" angegeben. Der Überdruck in den Reinräumen 6 kann durch ein Lochblech 42 oder ein anderes luftdurchlässiges Auflageteil gebildet werden. Unterhalb dieses Lochbleches 42 kann die Luft entweder ungehindert nach unten strömen oder an einem mit Abstand unterhalb des Lochbleches befindlichen Boden umgelenkt werden.

Werden die beiden Behältnisse 36 und 39 zur Übergabe der Halbleiterscheiben in die in Fig. 5 dargestellte Lage gebracht, in der ihre Übergabeöffnungen 38 und 40 benachbart zueinander liegen, dann muß der diese Übergabeöffnungen umgebende Bereich nicht gegen den Umgebungsraum 41 abgedichtet werden. Infolge des Überdruckes in beiden Behältnissen 36 und 39 strömt die reine Luft in Richtung der gezeichneten Pfeile allseitig längs des die Übergabeöffnungen umgebenden Bereiches in den Umgebungsraum 41. Dadurch wird auf konstruktiv sehr einfache Weise eine einwandfreie Abdichtung der Reinräume 6 gegen den Umgebungsraum 41 erzielt, d.h. es können keine Schmutzpartikelchen aus dem Umgebungsraum 41 in die Reinräume 6 gelangen. Die Überdrücke in den beiden Reinräumen 6 sind gleich oder zumindest annähernd gleich. Aufgrund der beschriebenen Abdichtung gegen Eintritt von Schmutzteilchen wird eine partikelfreie Übergabezone 43 zwischen den beiden Behältern 36 und 39 gebildet, in der die Halbleiterscheiben ohne Gefahr der Verschmutzung übergeben werden können.

Anstelle des einen Behältnisses 36 oder 39 kann auch ein stationärer Reinraum mit einer entsprechenden Übergabeöffnung vorgesehen sein. Dieser stationäre Reinraum kann an einem Prozeßgerät vorgesehen sein oder kann beispielsweise auch ein begehbarer Großreinraum sein.

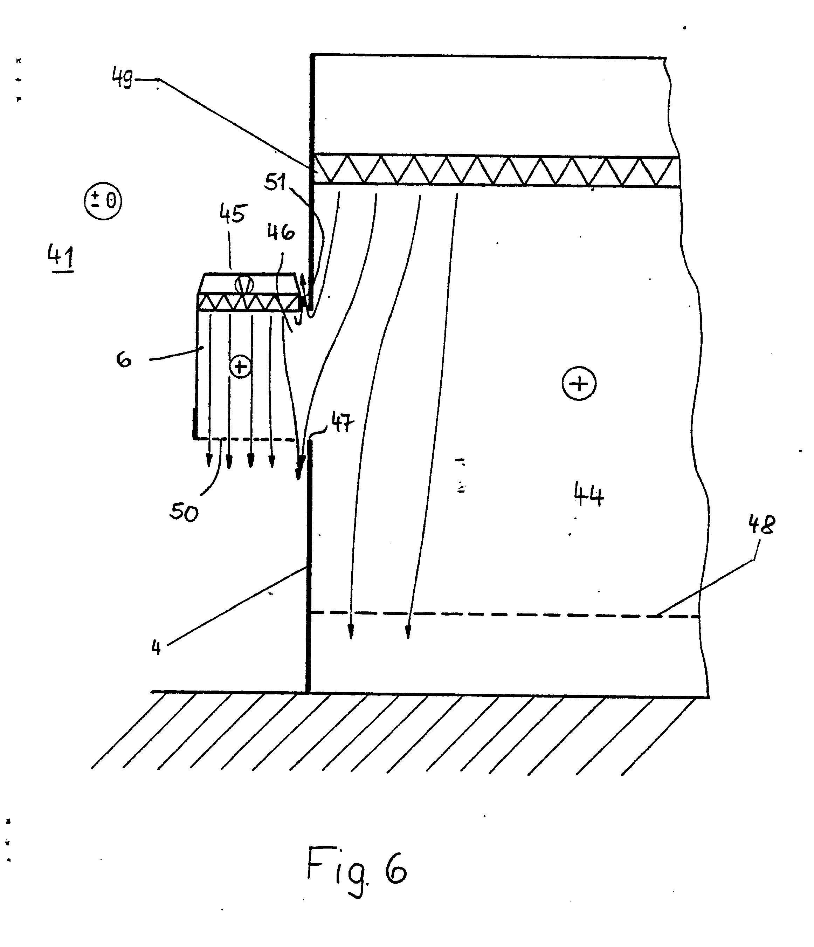

Fig. 6 zeigt die Möglicheit, aus einem Behältnis die Halbleiterscheiben ohne Gefahr der Verschmutzung in einen begehbaren Reinraum 44 zu übergeben. Er wird ebenfalls von Reinluft annähernd laminar durchströmt (Pfeile in Fig. 6). Das Behältnis 45 ist an einer Seitenwand mit einer Übergabeöffnung 46 versehen, die in der Übergabestellung gemäß Fig. 6 benachbart zu einer Übergabe öffnung 47 des Reinraumes 44 liegt. Der Überdruck im Reinraum 44, durch " + " gekennzeichnet, wird durch einen gelochten Doppelboden 48 oder dgl. erzeugt. Die Luft wird von einer (nicht dargestellten) Ventilatoreinheit angesaugt und durch mindestens einen Hochleistungs-Schwebstofffilter 49 in den Reinraum 44 gedrückt.

Im Reinraum 6 des Behältnisses 45 wird der Überdruck in der beschriebenen Weise durch ein Lochblech 50 oder dgl. erzeugt.

In der Übergabestellung gemäß Fig. 6 wird infolge des in beiden Reinräumen 44 und 6 gleichen oder annähernd gleichen Überdruckes, bezogen auf den Druck "± 0" im Umgebungsraum 41, der in Fig. 6 durch Pfeile gekennzeichnete Strömungsverlauf der reinen Luft erreicht. Sie strömt allseits längs des Randes der Übergabeöffnungen 46, 47 zwischen dem Behältnis 45 und der entsprechenden Wandung des Reinraumes 44 nach außen und verhindert somit den Zutritt von Schmutzpartikeln aus dem Umgebungsraum 41 durch den Spaltbereich 51 zwischen Behältnis und Reinraumwand.

Es ist auch möglich, das Behältnis direkt mit der der Ventilatoreinheit gegenüberliegenden offenen Seite (ohne Lochblech) an die jeweilige Übergabeöffnung des anderen Behältnisses 39 oder des Reinraumes 44 anzusetzen. Hierbei wird die Übergabeöffnung des Behältnisses durch die offene Seite dieses Behältnisses gebildet. In diesem Falle ist die Strömung in diesem Behältnis entgegengerichtet der aus der Übergabeöffnung des anderen Behältnisses oder des Reinraumes 44 austretenden Luft. Auch hierbei wird durch Abstimmung der beiden Drücke erreicht, daß ohne zusätzliche Dichtungsmaßnahmen der Zutritt von Schmutzteilchen aus dem Umgebungsraum sicher verhindert wird.

Die Ausführungsbeispiele sind anhand von Halbleiterscheiben 2 beschrieben worden. Selbstverständlich können die Behältnisse und das Übergabeverfahren auch überall dort angewendet werden, wo es auf eine Handhabung von Gegenständen im Reinraum bzw. unter reinraumgerechten Bedingungen ankommt. Beispielsweise ist es möglich, dieses Behältnis für Arzneimittel, Chemikalien, im Bereich der Gentechnik, der Virologie und dgl. zu verwenden.

## Ansprüche

1. Behältnis zur Handhabung von Halbleiterelementen während ihrer Herstellung, die in einem Träger angeordnet sind, der in einem Reinluftbereich des Behältnisses liegt, dadurch gekennzeichnet, daß die Halbleiterelemente (2) von einem gerichteten, zumindest annähernd laminaren Reinluftstrom im Reinluftbereich (6,6a) umspült sind.

2. Behältnis nach Anspruch 1, dadurch gekennzeichnet, daß der Reinluftbereich durch einen Reinraum (6,6a) gebildet ist, der in Strömungsrichtung der Reinluft offen ist.

3. Behältnis nach Anspruch 1 oder 2, dadurch gekennzeichnet, daß es mindestens einen Ventilator (10,10a) aufweist, dem in Strömungsrichtung mindestens ein Hochleistungs-Schwebstoffilter (9,9a) nachgeschaltet ist, der vorzugsweise den Reinraum (6,6a) an einer Seite begrenzt.

4. Behältnis nach einem der Ansprüche 1 bis 3, dadurch gekennzeichnet, daß es mit mindestens einer Stromversorgungseinrichtung (11,32), vorzugsweise einem Akku, für den Ventilator (10,10a) versehen ist.

5. Behältnis nach einem der Ansprüche 1 bis 4, dadurch gekennzeichnet, daß es mindestens einen Stromanschluß (12) aufweist.

6. Behältnis nach einem der Ansprüche 1 bis 5, dadurch gekennzeichnet, daß im Reinraum (6,6a) ein Überdruck herrscht, bezogen auf den Druck im Umgebungsraum.

7. Behältnis nach einem der Ansprüche 1 bis 6, dadurch gekennzeichnet, daß die Reinluft im Reinluftbereich (6,6a) eine Strömungsgeschwindigkeit von etwa 0,45 m/sec hat.

8. Behältnis nach einem der Ansprüche 1 bis 7, dadurch gekennzeichnet, daß es im Austrittsbereich der Reinluft aus dem Reinraum (6,6a) mindestens ein Lochblech aufweist.

9. Behältnis nach einem der Ansprüche 1 bis 8, dadurch gekennzeichnet, daß es einen Transportwagenteil (31) aufweist, auf dem der Träger (1) angeordnet ist, und daß vorzugsweise am Transportwagenteil (31) mindestens eine Hebeeinrichtung (34) vorgesehen ist, mit der ein die Träger (1) umschließender Gehäuseteil (33) anhebbar ist.

10. Behältnis nach einem der Ansprüche 1 bis 9, dadurch gekennzeichnet, daß es auf einem Transportwagen (17) zu einem Prozeßgerät (13) fahrbar ist, das einen Ent-und Beladeraum (14) aufweist, der von Reinluft zumindest annähernd laminar durchströmt und vorzugsweise in Strömungsrichtung offen ist.

11. Behältnis nach Anspruch 10, dadurch gekennzeichnet, daß das Prozeßgerät (13) mindestens einen Ventilator (16) aufweist, dem in Strömungsrichtung mindestens ein Hochleistungs-Schwebestoffilter (15) nachgeschaltet ist.

12. Verfahren zur partikelfreien Übergabe von Produkten, vorzugsweise von Halbleiterelementen, zwischen zwei Reinluftbereichen, dadurch gekennzeichnet, daß beide Reinluftbereiche (6, 44) von Reinluft durchströmt sind, und daß zumindest in einem Reinluftbereich ein höherer statischer Druck herrscht als im mit unzulässig vielen Partikeln belasteten Umgebungsraum (41).

13. Verfahren nach Anspruch 12, dadurch gekennzeichnet, daß in beiden Reinluftbereichen (6,44) annähernd der gleiche statische Druck herrscht, und daß vorzugsweise die Reinluft allseitig längs des Randes der Übergabeöffnung (38,40;46,47) nach außen in den Umgebungsraum (41) strömt.

A 1-87 401/sch
30.10.1987

Fig. 1

Fig. 2

Fig. 3

Fig. 4

Fig. 5

Fig. 6